# EUROPEAN PATENT APPLICATION

(11) **EP 4 596 119 A1**
(43) Date of publication of application: **06.08.2025**
(21) Application number: 23871302.8
(22) Date of filing: 01.06.2023
(51) Int. Cl.: B06B 1/06

(54) **OSCILLATOR AND BIOSTIMULATION DEVICE**

(30) Priority: 26.09.2022 JP 2022152731
(71) Applicant: Techno Link Co., Ltd., Niigata-shi, Niigata 956-0804 (JP)
(72) Inventor: KOBAYASHI, Tatsuyuki, Niigata-shi Niigata 956-0804 (JP)
(74) Representative: Mewburn Ellis LLP
(86) International application number: PCT/JP2023/020540
(87) International publication number: WO 2024/070056

(57) **Abstract**

Disclosed is an oscillation device including: a piezoelectric element capable of resonating at a first frequency and a second frequency higher than the first frequency; a transistor including a control electrode connected to the piezoelectric element, a power supply-side electrode, and a ground-side electrode; a first coil connected to the ground-side electrode of the transistor; a first capacitor connected in parallel to the first coil; and a second capacitor connected between the first capacitor and the control electrode of the transistor. A resonant frequency of a resonant circuit constituted by the first coil and the first capacitor is higher than the first frequency and lower than the second frequency.

## Description

### TECHNICAL FIELD

The present invention relates to an oscillation device and a living body stimulation device.

The present application claims priority based on Japanese Patent Application No. 2022-152731 filed on September 26, 2022, the contents of which are incorporated herein by reference.

### BACKGROUND ART

Oscillation devices that cause piezoelectric elements to oscillate and generate signals or vibrations are known in the art (see, for example, Patent Literature 1).

### CITATION LIST

### PATENT LITERATURE

Patent Literature 1: JP 2011-120189A

### SUMMARY

### TECHNICAL PROBLEM

A typical oscillation device causes a piezoelectric element to oscillate at a fundamental wave frequency, but depending on the use of the oscillation device, the oscillation device may cause the piezoelectric element to oscillate, for example, at harmonic frequencies which are higher than the frequency of the fundamental wave. However, for example, changing the operating condition of the piezoelectric element may make it difficult for the oscillation device to cause the piezoelectric element to stably oscillate at harmonic frequencies.

The present invention has been achieved in view of such conventional issues, and an objective of the invention is to provide an oscillation device and a living body stimulation device capable of causing a piezoelectric element to stably oscillate at a frequency higher than that of the fundamental wave.

### SOLUTION TO PROBLEM

A first aspect of a primary invention to achieve the aforementioned objective is an oscillation device including: a piezoelectric element capable of resonating at a first frequency and a second frequency higher than the first frequency; a transistor including a control electrode connected to the piezoelectric element, a power supply-side electrode, and a ground-side electrode; a first coil connected to the ground-side electrode of the transistor; a first capacitor connected in parallel to the first coil; and a second capacitor connected between the first capacitor and the control electrode of the transistor. A resonant frequency of a resonant circuit constituted by the first coil and the first capacitor is higher than the first frequency and lower than the second frequency.

A second aspect of a primary invention to achieve the aforementioned objective is a living body stimulation device configured to transmit vibration to a living body, the living body stimulation device including: a piezoelectric element capable of resonating at a first frequency and a second frequency higher than the first frequency; a transistor including a control electrode connected to the piezoelectric element, a power supply-side electrode, and a ground-side electrode; a first coil connected to the ground-side electrode of the transistor; a first capacitor connected in parallel to the first coil; and a second capacitor connected between the first capacitor and the control electrode of the transistor. A resonant frequency of a resonant circuit constituted by the first coil and the first capacitor is higher than the first frequency and lower than the second frequency.

### EFFECTS OF INVENTION

The present invention can provide an oscillation device and a living body stimulation device capable of causing a piezoelectric element to stably oscillate at a frequency higher than that of the fundamental wave.

### BRIEF DESCRIPTION OF DRAWINGS

FIG. 1 is a diagram illustrating an example of a living body stimulation device 10.
FIG. 2 is a diagram illustrating an example of an oscillation circuit 20.
FIG. 3 is a diagram illustrating an example of characteristics of a piezoelectric element X1.
FIG. 4 is a diagram for explaining changes in characteristics of the piezoelectric element X1.
FIG. 5 is a diagram for explaining an example of processes executed in the living body stimulation device 10.

### DESCRIPTION OF EMBODIMENTS

At least the following features are disclosed in the present description and accompanying drawings. Herein, the same, or similar, constituent elements/members illustrated in the figures are accompanied by the same reference signs, and overlapping explanation thereof is omitted as appropriate.

In the present embodiment, the term "connected" refers to a state in which elements are connected electrically, unless specifically stated otherwise. Therefore, the term "connected" not only encompasses cases where two components are connected by a wiring line, but also encompasses cases where they are connected, for example, via a resistor.

### PRESENT EMBODIMENT:

Configuration of Living Body Stimulation Device 10:

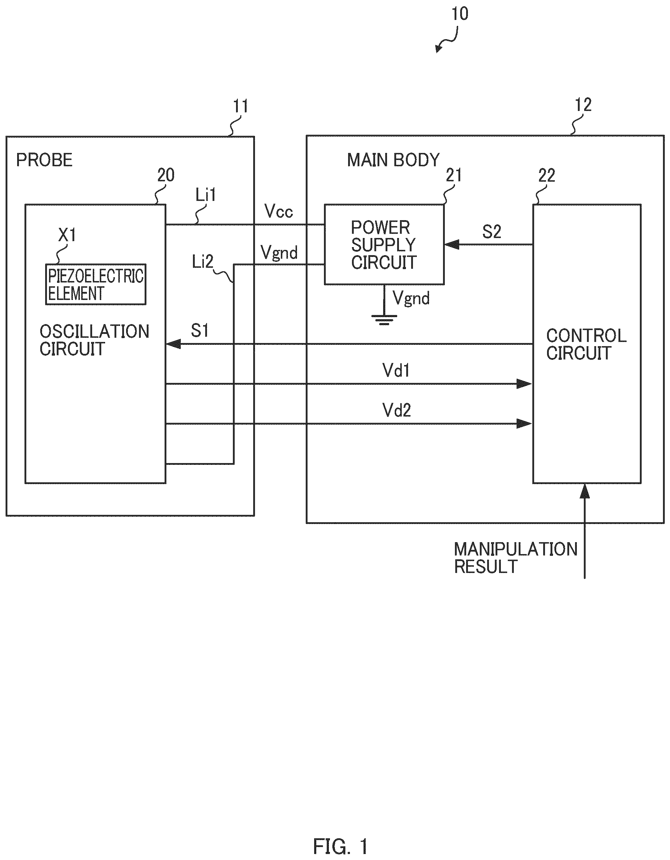

FIG. 1 is a diagram illustrating an example of a configuration of a living body stimulation device 10, which is an embodiment of the present invention. The living body stimulation device 10 is an oscillation device configured to transmit ultrasonic vibration generated by causing oscillation of a piezoelectric element X1 (described below) to, for example, a treatment area of a living body, and is constituted by including a probe 11 and a main body 12.

The probe 11 is a member configured to transmit vibration from the piezoelectric element X1 to the living body by, for example, being placed in contact with the human skin, and is attached to the main body 12 via wiring lines such as a power supply line Li1, a ground line Li2, etc. It should be noted that, in the present embodiment, in addition to the power supply line Li1 and the ground line Li2, there are also wiring lines between the probe 11 and the main body 12 for exchanging signal S1 and voltages Vd1, Vd2, which are described below.

The probe 11 includes an oscillation circuit 20. The main body 12 includes a power supply circuit 21 and a control circuit 22. It should be noted that, although the probe 11 includes the oscillation circuit 20 in the present embodiment, for example, the probe may include only the piezoelectric element X1, and constituent elements of the oscillation circuit 20, other than the piezoelectric element X1, may be provided in the main body 12.

The oscillation circuit 20 is a circuit that, when supplied with power from the power supply circuit 21, is configured to cause the piezoelectric element X1 to oscillate at a frequency corresponding to a manipulation result. Further, although details will be described further below, the oscillation circuit 20 outputs, to the control circuit 22: a voltage Vd1 corresponding to a current flowing through a transistor (described below) configured to cause the piezoelectric element X1 to operate; and a voltage Vd2 corresponding to an amplitude of an oscillation voltage Vosc (described below) of the piezoelectric element X1.

The power supply circuit 21 is a circuit configured to supply, to the oscillation circuit 20, a power supply voltage corresponding to a frequency at which the piezoelectric element X1 oscillates. Although details will be described further below, the power supply circuit 21 of the present embodiment supplies, to the oscillation circuit 20, a power supply voltage Vcc at a first level V1 in case where the piezoelectric element X1 is to be oscillated at a fundamental wave frequency. On the other hand, the power supply circuit 21 supplies, to the oscillation circuit 20, a power supply voltage Vcc at a second level V2, which is different from the first level V1, in case where the piezoelectric element X1 is to be oscillated at a frequency of a triple harmonic (referred to hereinafter as "third harmonic") of the fundamental wave.

It should be noted that the first level V1 and the second level V2 are set such that the oscillation circuit 20 operates in a desired manner at respective frequencies of the fundamental wave and the third harmonic. These levels vary depending on the characteristics of the elements (e.g., piezoelectric element X1) constituting the oscillation circuit 20. In the present embodiment, the "first level V1" is, for example, 12 V, and the "second level V2" is a voltage (e.g., 15 V) of a level that is different from the first level V1.

The control circuit 22 is configured to control the operations of the oscillation circuit 20 and the power supply circuit 21 based on, for example, a user's manipulation result. Although details will be described further below, the control circuit 22 outputs signals S1, S2 corresponding to the manipulation result respectively to the oscillation circuit 20 and the power supply circuit 21. Further, when the control circuit 22 determines, based on voltages Vd1, Vd2, that operation of the piezoelectric element X1 is abnormal, the control circuit outputs a predetermined signal S2 and makes the power supply circuit 21 stop generating the power supply voltage Vcc in order to stop the oscillation of the piezoelectric element X1.

Configuration of Oscillation Circuit 20:

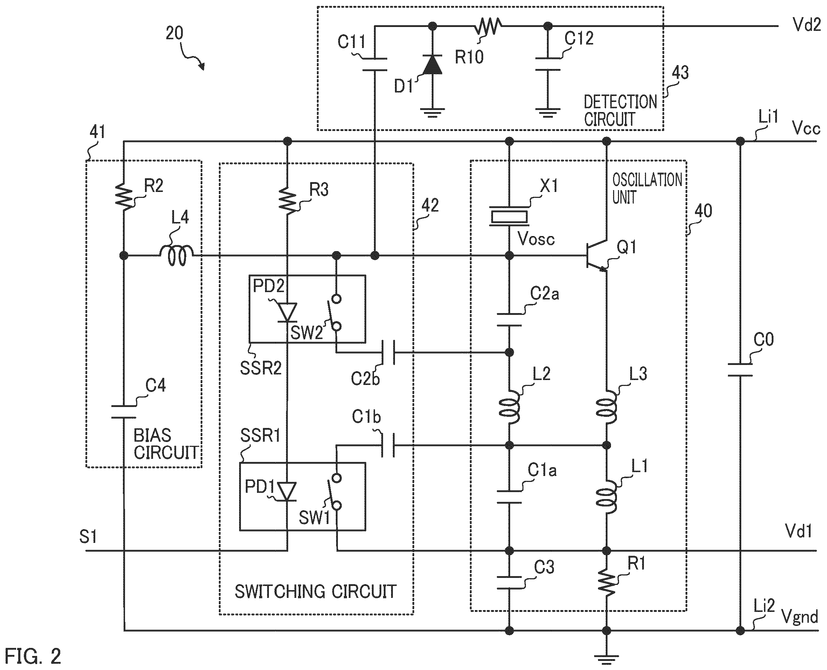

FIG. 2 is a diagram illustrating an example of the oscillation circuit 20 which is configured to cause the piezoelectric element X1 to oscillate at respective frequencies of the fundamental wave and third harmonic. The oscillation circuit 20 is constituted by including a power supply line Li1, a ground line Li2, a capacitor C0, an oscillation unit 40, a bias circuit 41, a switching circuit 42, and a detection circuit 43.

The power supply line Li1 is a line to which the power supply voltage Vcc, which is the positive-side voltage from the power supply circuit 21, is applied. The ground line Li2 is a line to which a ground voltage Vgnd (0 V in this example), which is the negative-side voltage from the power supply circuit 21, is applied.

The capacitor C0 for stabilizing the power supply voltage Vcc applied to the power supply line Li1 is connected between the power supply line Li1 and the ground line Li2.

Oscillation Unit 40:
The oscillation unit 40 is a unit configured to cause the piezoelectric element X1 to oscillate, and is constituted by including the piezoelectric element X1, a transistor Q1, inductors L1 to L3, capacitors C1a, C2a, C3, and a resistor R1.

The piezoelectric element X1 is a ceramic vibrator that vibrates (resonates) when an alternating-current voltage of a predetermined frequency is applied. For example, the piezoelectric element X1 of the present embodiment has reactance characteristics as illustrated in FIG. 2. More specifically, the piezoelectric element X1 has characteristics wherein the fundamental wave of oscillation has frequency f1, the third harmonic has frequency f2 (=3×f1), and a fifth harmonic has frequency f3 (=5×f1). It should be noted that, in the present embodiment, a voltage generated at a node where the piezoelectric element X1 and the transistor Q1 are connected due to oscillation of the piezoelectric element X1 is defined as oscillation voltage Vosc. Herein, the piezoelectric element X1 corresponds to an element capable of resonating at frequencies f1, f3, and f5.

The transistor Q1 is an element that constitutes a positive feedback circuit together with later-described inductors L3, L1, L2, capacitors C1a, C2a, and the piezoelectric element X1, and that causes the piezoelectric element X1 to operate in an inductive range. The base electrode of the transistor Q1 is connected to one end of the piezoelectric element X1, the collector electrode is connected to the other end of the piezoelectric element X1 via the power supply line Li1, and the emitter electrode is connected to the inductor L3.

It should be noted that the base electrode corresponds to "control electrode", the collector electrode corresponds to "power supply-side electrode", and the emitter electrode corresponds to "ground-side electrode". In the present embodiment, an NPN transistor is used as the transistor Q1, but other types of transistors, such as an NMOS transistor etc., may be used. In this case, for example, the gate electrode of the NMOS transistor corresponds to the "control electrode", the drain electrode corresponds to the "power supply-side electrode", and the source electrode corresponds to the "ground-side electrode".

The inductor L1 is connected to the transistor Q1 via the inductor L3. The capacitor C1a is connected in parallel to the inductor L1, and thus, the inductor L1 and the capacitor C1a constitute a so-called resonant circuit. It should be noted that the inductor L3 is an element that compensates for the waveform outputted from the emitter electrode of the transistor Q1.

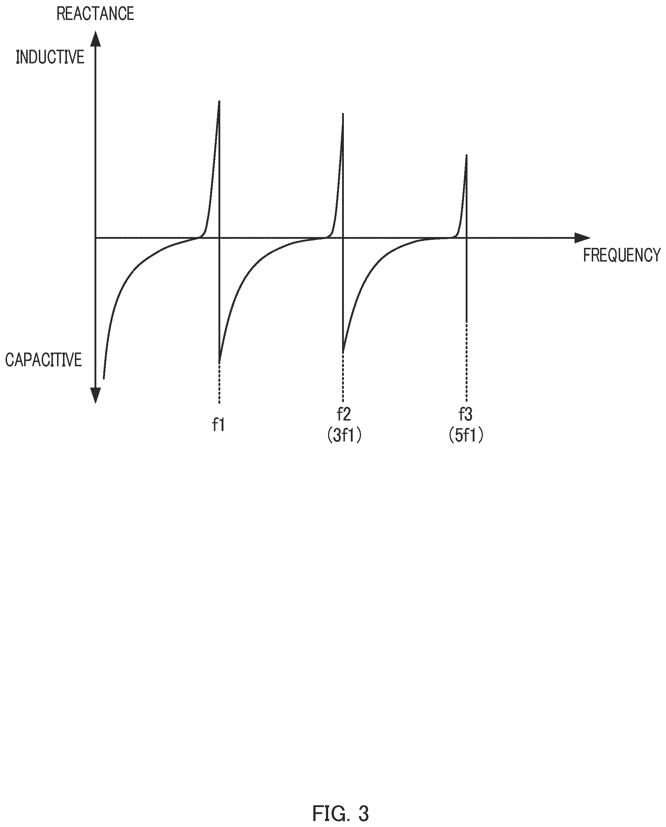

The piezoelectric element X1 of the present embodiment oscillates in a range wherein the reactance of the piezoelectric element X1 is inductive. Further, the piezoelectric element X1 oscillates at the fundamental wave frequency in cases where the frequency of the alternating-current voltage applied to the piezoelectric element X1 is lower than frequency f1 of FIG. 3. It should be noted that FIG. 3 is a conceptual diagram illustrating an example of characteristics of the piezoelectric element X1. In reality, the piezoelectric element X1 includes various spurious resonances other than the frequencies f1 to f3, but they are omitted herein for convenience's sake.

To make the piezoelectric element X1 operate at the frequency f2 of the third harmonic, it is necessary that the frequency of the alternating-current voltage applied to the piezoelectric element X1 be slightly lower than the frequency f3, at which the reactance of the piezoelectric element X1 is inductive. In the present embodiment, in order to sustain the oscillation of the piezoelectric element X1, the resonance point (resonant frequency fr) of the resonant circuit constituted by the inductor L1 and the capacitor C1a is set lower than the resonance point (oscillation frequency) of the piezoelectric element X1. More specifically, the resonant frequency fr of the resonant circuit constituted by the inductor L1 and the capacitor C1a is set higher than the frequency f1 of the fundamental wave and lower than the frequency f2 of the third harmonic.

By setting the resonant frequency fr within the aforementioned range, the piezoelectric element X1 operates as a part of the positive feedback circuit including the other elements of the oscillation unit 40 (e.g., the inductor L2 and the capacitor C2a described below). In the present embodiment, by setting the resonant frequency fr within the aforementioned range and also adjusting the values of the elements constituting the positive feedback circuit (e.g., the inductor L2 and the capacitor C2a), the oscillation voltage Vosc of the piezoelectric element X1 can have the frequency of the third harmonic.

The inductor L2 and the capacitor C2a are each elements for returning a signal from the resonant circuit to the base electrode of the transistor Q1, and are connected between the capacitor C1a and the base electrode of the transistor Q1.

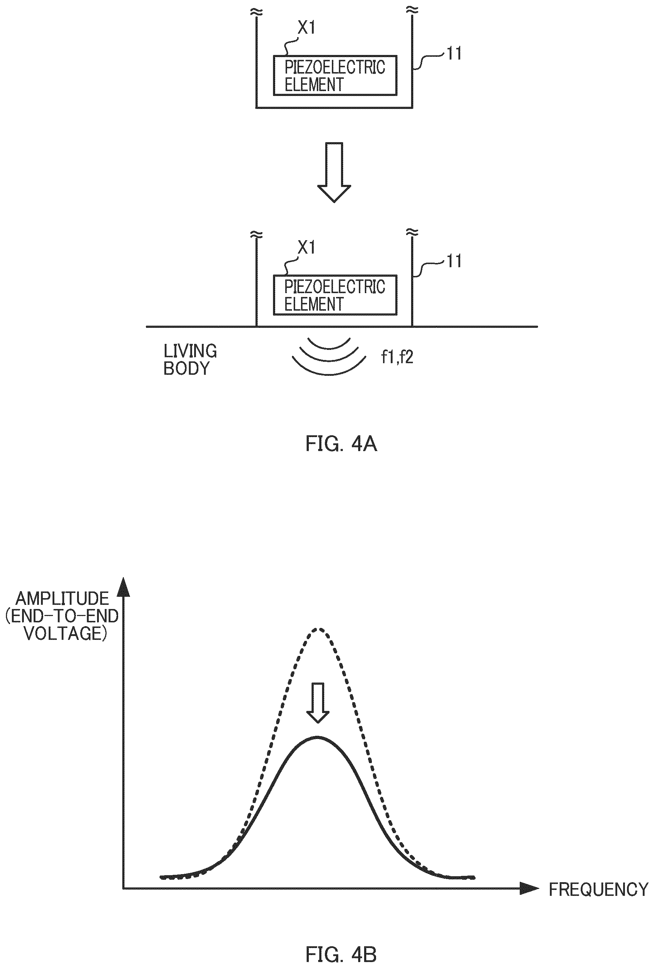

Hereinbelow, the role of the inductor L2 will be described with reference to FIG. 4. FIG. 4(a) is a diagram for explaining a state in which a head part of the probe 11, to which the piezoelectric element X1 is installed, is in contact with the living body. FIG. 4(b) is a diagram for explaining an overview of the Q factor of the piezoelectric element X1 before and after the head part of the probe 11 contacts the living body. It should be noted that the Q factor is a numerical value indicating the sharpness of resonance.

In FIG. 4(b), the dotted line is an example of a waveform of the Q factor of the piezoelectric element X1 in a state where the probe 11 is not in contact with the living body, and the solid line is an example of a waveform of the Q factor of the piezoelectric element X1 in a state where the probe 11 is in contact with the living body. As illustrated by the solid line in FIG. 4(b), in a state where the probe 11 is in contact with the living body, the vibration of the piezoelectric element X1 is absorbed by the human body, resulting in an increase in mechanical vibration loss. As a result, the equivalent resistance of the piezoelectric element X1 increases, thus suppressing the vibration of the piezoelectric element X1. Thus, the amplitude of the end-to-end voltage of the piezoelectric element X1 becomes small, and oscillation of the piezoelectric element X1 at the third harmonic frequency may stop.

In the present embodiment, in order to increase the amplitude of the signal returned from the resonant circuit constituted by the inductor L1 and the capacitor C1a to the base electrode of the transistor Q1, the inductor L2 is connected between the capacitor C1a and the transistor Q1. As a result, in the present embodiment, even when the equivalent resistance of the piezoelectric element X1 becomes large, the piezoelectric element X1 can be caused to oscillate stably at the third harmonic frequency.

It should be noted that, in the present embodiment, after choosing the transistor Q1, the piezoelectric element X1 and the resonant circuit, for example, the inductance value of the inductor L2 and the capacitance value of the capacitor C2a are defined such that the piezoelectric element X1 oscillates stably at the third harmonic frequency.

The resistor R1 is an element for detecting a current flowing through the transistor Q1, and is connected between the inductor L1 and the ground. The capacitor C3 is connected in parallel to the resistor R1, and is an element that passes, to the ground, high-frequency components of the current flowing through the transistor Q1. Therefore, the resistor R1 is capable of detecting low-frequency components (mainly the direct current) of the current flowing through the transistor Q1.

In the present embodiment, a voltage of a node where the inductor L1 and the resistor R1 are connected is defined as voltage Vd1. Therefore, the level of the voltage Vd1 becomes higher as the current flowing through the transistor Q1 increases.

It should be noted that the inductor L1 corresponds to "first coil", and the inductor L2 corresponds to "second coil". Further, the capacitor C1a corresponds to "first capacitor", the capacitor C2a corresponds to "second capacitor", the capacitor C1b corresponds to "third capacitor", and the capacitor C2b corresponds to "fourth capacitor".

Bias Circuit 41:
The bias circuit 41 is a circuit configured to generate a bias voltage to be applied to the base electrode of the transistor Q1, and is constituted by including a resistor R2, an inductor L4, and a capacitor C4. The resistor R2 and the inductor L4 apply, to the base electrode of the transistor Q1, the power supply voltage Vcc applied to the power supply line Li1. It should be noted that the inductor L4 is an element that prevents the oscillation voltage Vosc-which has a large amplitude generated when the piezoelectric element X1 oscillates-from being applied to the resistor R2.

The capacitor C4 is an element that passes, to the ground, the high-frequency component current from the base electrode of the transistor Q1. Thus, the capacitor C4, together with the inductor L4, is capable of preventing a large high-frequency voltage from being generated in the resistor R2.

Switching Circuit 42:
The switching circuit 42 is a circuit configured to switch between making the piezoelectric element X1 oscillate at the fundamental wave frequency f1 or at the third harmonic frequency f2. The switching circuit 42 is constituted by including a resistor R3, solid-state relays SSR1, SSR2, and capacitors C1b, C2b.

The resistor R3 is an element for supplying a current from the power supply line Li1 to the solid-state relays SSR1, SSR2 at the time of turning on the solid-state relays SSR1, SSR2.

The solid-state relay SSR1 is constituted by including a light-emitting diode PD1 and a switch SW1. The light-emitting diode PD1, for example, lights up when the signal S1 from the control circuit 22 of FIG. 1 is at a low level ("L level"), and turns off when the signal S1 is at a high level ("H level").

The switch SW1 is an element connected in series to the capacitor C1b, and turns on when the light-emitting diode PD1 lights up and turns off when the light-emitting diode PD1 turns off.

Like the solid-state relay SSR1, the solid-state relay SSR2 is constituted by including a light-emitting diode PD2 and a switch SW2. The light-emitting diode PD2 lights up when the signal S1 is at L level, and turns off when the signal S1 is at H level.

The switch SW2 is an element connected in series to the capacitor C2b, and turns on when the light-emitting diode PD2 lights up and turns off when the light-emitting diode PD2 turns off.

The capacitor C1b is an element used when the piezoelectric element X1 is caused to oscillate at the fundamental wave frequency f1. One end of the capacitor C1b is connected to one end of the capacitor C1a, and the other end of the capacitor C1b is connected to the other end of the capacitor C1a via the switch SW1. Thus, when the switch SW1 turns on, the capacitor C1a and the capacitor C1b are connected in parallel.

The capacitor C2b is an element used when the piezoelectric element X1 is caused to oscillate at the fundamental wave frequency f1. One end of the capacitor C2b is connected to one end of the capacitor C2a, and the other end of the capacitor C2b is connected to the other end of the capacitor C2a via the switch SW2. Thus, when the switch SW2 turns on, the capacitor C2a and the capacitor C2b are connected in parallel.

It should be noted that the capacitance value of each of the capacitors C1b and C2b is selected such that the frequency of the alternating-current voltage applied to the piezoelectric element X1 has the fundamental wave frequency f1. Thus, in the present embodiment, when the switches SW1, SW2 are on, the oscillation unit 40 causes the piezoelectric element X1 to oscillate at the fundamental wave frequency f1, and when the switches SW1, SW2 are off, the oscillation unit 40 causes the piezoelectric element X1 to oscillate at the third harmonic frequency f2.

It should be noted that the switch SW1 corresponds to "first switch", and the switch SW2 corresponds to "second switch".

Further, the fundamental wave frequency f1 corresponds to "first frequency", and the third harmonic frequency f2 corresponds to "second frequency". The power supply voltage Vcc at the first level V1 corresponds to "power supply voltage at a first level", and the power supply voltage Vcc at the second level V2 corresponds to "power supply voltage at a second level". Further, the signal S1 at L level corresponds to "first instruction", and the signal S1 at H level corresponds to "second instruction".

Detection Circuit 43:
The detection circuit 43 is a circuit configured to detect the amplitude of the oscillation voltage Vosc of the piezoelectric element X1 and output it as voltage Vd. The detection circuit 43 is constituted by including capacitors C11, C12, a diode D1, and a resistor R10.

The capacitor C11 is an element that allows passage of high-frequency components of the oscillation voltage Vosc at the node where the transistor Q1 and the piezoelectric element X1 are connected.

The diode D1 is an element that rectifies the high-frequency components of the oscillation voltage Vosc having passed through the capacitor C11. The resistor R10 and the capacitor C12 constitute an integrating circuit configured to integrate a rectified voltage which has been rectified by the diode D1. As a result, the level of the voltage Vd2 of the capacitor C12 becomes higher as the amplitude of the oscillation voltage Vosc becomes larger.

As described above, from the oscillation circuit 20 are outputted: voltage Vd1 corresponding to the current flowing through the transistor Q1; and voltage Vd2 corresponding to the amplitude of the oscillation voltage Vosc. Generally speaking, in cases where the probe 11 is being used with respect to the human skin in an expected state, the voltages Vd1 and Vd2 will change within a predetermined range. However, for example, if the probe 11 is used in an unexpected state, the voltages Vd1 and Vd2 may go beyond the predetermined range.

Although details will be described further below, the control circuit 22 of the present embodiment is capable of grasping whether or not the probe 11 is operating in an expected state based on the voltages Vd1 and Vd2. Further, if it is determined, based on the voltages Vd1 and Vd2, that the probe 11 is not operating in an expected state, the control circuit 22 stops the operation of the power supply circuit 21.

It should be noted that, hereinbelow, a state in which the probe 11 is not operating in an expected state is also described as "the probe 11 is in an abnormal state" or "the piezoelectric element X1 is in an abnormal state", as appropriate. It should be noted that an example of an "abnormal state" may include a state wherein the piezoelectric element X1 is caused to operate for a long time without the probe 11 contacting the human skin and thus the piezoelectric element X1 has generated heat.

Operation of Living Body Stimulation Device 10:

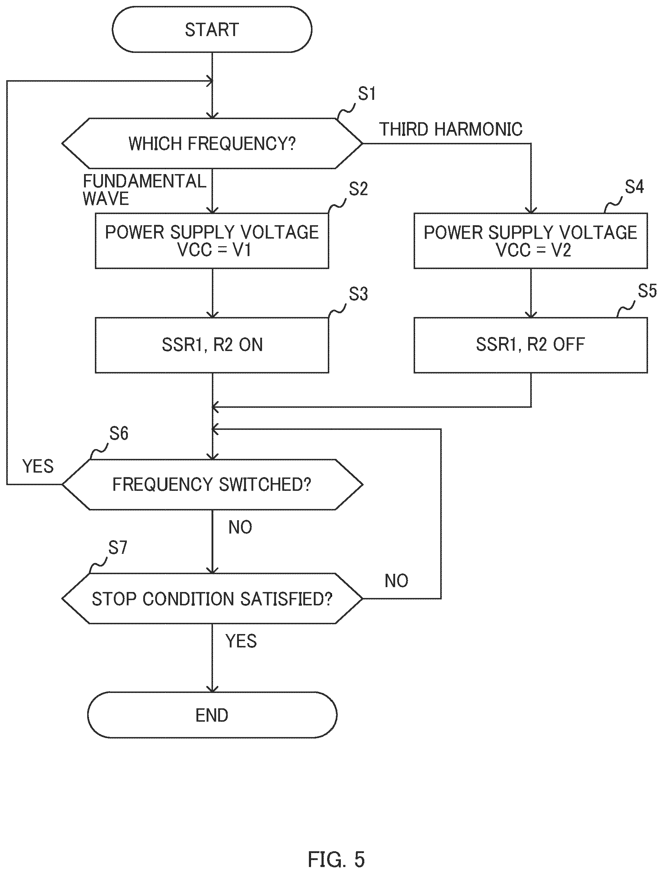

FIG. 5 is a flowchart for explaining an operation of the living body stimulation device 10. First, a user manipulates the living body stimulation device 10 and sets the frequency of the vibration of the probe 11. Based on the manipulation result for setting the frequency, the control circuit 22 determines the frequency of the vibration of the probe 11 (S1).

If the fundamental wave has been selected (S1: fundamental wave), the control circuit 22 outputs a predetermined signal S2 to the power supply circuit 21, and makes the power supply circuit 21 generate a power supply voltage Vcc at the first level V1 (S2). Also, the control circuit 22 outputs an L-level signal S1 to the oscillation circuit 20, and thus, the solid-state relays SSR1, SSR2 turn on (i.e., the switches SW1, SW2 turn on) (S3). As a result, the piezoelectric element X1 of the oscillation circuit 20 oscillates at the fundamental wave frequency f1, and thus, the probe 11 generates a signal having frequency f1.

On the other hand, if the third harmonic has been selected (S1: third harmonic), the control circuit 22 outputs a predetermined signal S2 to the power supply circuit 21, and makes the power supply circuit 21 generate a power supply voltage Vcc at the second level V2 (S4). Also, the control circuit 22 outputs an H-level signal S1 to the oscillation circuit 20, and thus, the solid-state relays SSR1, SSR2 turn off (i.e., the switches SW1, SW2 turn off) (S5). As a result, the piezoelectric element X1 of the oscillation circuit 20 oscillates at the third harmonic frequency f2, and thus, the probe 11 generates a signal having frequency f2.

It should be noted that the equivalent resistance of the piezoelectric element X1 when the piezoelectric element X1 oscillates at the third harmonic frequency f2 is greater than the equivalent resistance of the piezoelectric element X1 when the piezoelectric element X1 oscillates at the fundamental wave frequency f1. Therefore, by making the power supply voltage Vcc higher when causing oscillation at the third harmonic frequency f2 compared to when causing oscillation at the fundamental wave frequency f1, the operating conditions of the piezoelectric element X1 can be made substantially the same. As a result, the intensity of the signal generated at the probe 11 becomes substantially the same, regardless of which frequency the user selects.

Further, based on the manipulation result, the control circuit 22 determines whether or not the frequency has been switched (S6). If the frequency has been switched (S6: Yes), the control circuit 22 executes process S1, and further executes processes corresponding to the switched frequency.

On the other hand, if the frequency has not been switched (S6: No), then the control circuit 22 determines whether or not the stop condition is satisfied (S7). Herein, "stop condition" may include, for example, either a case where the user has executed a manipulation to stop the operation of the living body stimulation device 10, or a case where the piezoelectric element X1 is in an abnormal state.

If the stop condition is not satisfied (S7: No), the control circuit 22 executes process S6. On the other hand, if the stop condition is satisfied (S7: Yes), the control circuit 22 controls the power supply circuit 21 to stop generation of the power supply voltage Vcc. As a result, the operation of the living body stimulation device 10 is stopped.

### SUMMARIZATION:

The living body stimulation device 10 of the present embodiment has been described above. In the oscillation circuit 20 of the living body stimulation device 10, the resonant frequency fr of the resonant circuit constituted by the inductor L1 and the capacitor C1a illustrated in FIG. 2 is set higher than the fundamental wave frequency f1 and lower than the third harmonic frequency f2. By setting the resonant frequency fr within this range, the piezoelectric element X1 can easily operate at the third harmonic frequency f2, and not the fundamental wave frequency f1. Thus, in the present embodiment, the oscillation voltage Vosc of the the piezoelectric element X1 can be set stably to the third harmonic frequency.

Further, for example, as illustrated in FIG. 4(b), when the probe 11 is placed in contact with the living body, the vibration of the piezoelectric element X1 is absorbed by the human body, and the equivalent resistance of the piezoelectric element X1 becomes large and the Q factor changes. Therefore, for example, in cases where a typical Colpitts oscillation circuit is used to cause the piezoelectric element X1 to operate at the third harmonic frequency f2, the oscillation of the piezoelectric element X1 may stop. In contrast, in the present embodiment, the signal of the resonant circuit is returned to the transistor Q1 via the inductor L2. Therefore, in the oscillation circuit 20, even when the equivalent resistance of the piezoelectric element X1 increases, the piezoelectric element X1 can be caused to oscillate stably.

Further, in the oscillation circuit 20, when the switches SW1, SW2 are turned on, the capacitor C1b is connected in parallel to the capacitor C1a, and the capacitor C2b is connected in parallel to the capacitor C2a. Further, the capacitors C1b and C2b are selected such that the piezoelectric element X1 oscillates at the fundamental wave frequency f1. Thus, in the present embodiment, the piezoelectric element X1 can be caused to oscillate at the fundamental wave frequency f1 and the third harmonic frequency f2.

Further, when the piezoelectric element X1 oscillates at the fundamental wave frequency f1, the power supply voltage Vcc is at the first level V1, and when the piezoelectric element X1 oscillates at the third harmonic frequency f2, the power supply voltage Vcc is at the second level V2. Thus, even when the equivalent resistance of the piezoelectric element X1 increases, the intensity of the vibration of the piezoelectric element X1 can be prevented from decreasing.

Further, the oscillation circuit 20 includes a resistor R1 configured to detect a current of the transistor Q1. Thus, for example, the control circuit 22 can grasp an overcurrent in the transistor Q1 based on the voltage Vd1.

Further, the oscillation circuit 20 includes a detection circuit 43 configured to detect a voltage Vd2 corresponding to the amplitude of the oscillation voltage Vosc. Thus, for example, the control circuit 22 can grasp the amplitude of the oscillation voltage Vosc based on the voltage Vd2.

Further, the control circuit 22 determines whether or not the piezoelectric element X1 is in an abnormal state based, for example, on the voltages Vd1 and Vd2 (e.g., process S7 of FIG. 5). Thus, in the present embodiment, the user can use the living body stimulation device 10 safely.

Further, the state of the solid-state relays SSR1, SSR2 can be switched by the signal S1 from the control circuit 22. Thus, compared to, for example, a case where probes need to be replaced corresponding respectively to the fundamental wave and the third harmonic, the operating frequency of the piezoelectric element X1 of the probe 11 can be switched promptly.

It should be noted that, although the oscillation circuit 20 of the present embodiment causes the piezoelectric element X1 to oscillate at respective frequencies of the fundamental wave and the third harmonic, this is not a limitation, and for example, the piezoelectric element may be caused to oscillate at frequencies of the third harmonic and the fifth harmonic.

The foregoing embodiments are to facilitate understanding of the present invention and are not to be construed as limiting the present invention. It goes without saying that the present invention may be modified or altered without departing from its gist and encompasses equivalents thereof.

### REFERENCE SIGNS LIST

10: Living body stimulation device;
11: Probe;
12: Main body;
20: Oscillation circuit;
21: Power supply circuit;
22: Control circuit;
40: Oscillation unit;
41: Bias circuit;
42: Switching circuit;
43: Detection circuit;
C0, C1a, C1b, C2a, C2b, C3, C4, C11, C12: Capacitor;
Q1: Transistor;
R1-R3, R10: Resistor;
D1: Diode;
X1: Piezoelectric element;
Li1: Power supply line;
Li2: Ground line;
PD1, PD2: Light-emitting diode;
SW1, SW2: Switch;
SSR1, SSR2: Solid-state relay.

## Claims

1. An oscillation device comprising:
a piezoelectric element capable of resonating at a first frequency and a second frequency higher than the first frequency;
a transistor including a control electrode connected to the piezoelectric element, a power supply-side electrode, and a ground-side electrode;
a first coil connected to the ground-side electrode of the transistor;
a first capacitor connected in parallel to the first coil; and
a second capacitor connected between the first capacitor and the control electrode of the transistor, wherein
a resonant frequency of a resonant circuit constituted by the first coil and the first capacitor is higher than the first frequency and lower than the second frequency.

2. The oscillation device according to claim 1, comprising
a second coil connected between the first capacitor and the second capacitor.

3. The oscillation device according to claim 2, comprising:
a first switch configured to turn on based on a first instruction for causing the piezoelectric element to resonate at the first frequency, and configured to turn off based on a second instruction for causing the piezoelectric element to resonate at the second frequency;
a second switch configured to turn on based on the first instruction, and configured to turn off based on the second instruction;
a third capacitor connected in series to the first switch; and
a fourth capacitor connected in series to the second switch, wherein
the first switch and the third capacitor are connected in parallel to the first capacitor, and
the second switch and the fourth capacitor are connected in parallel to the second capacitor.

4. The oscillation device according to claim 3, comprising:
a power supply line to which a power supply voltage for making the transistor operate is applied; and
a power supply circuit configured to apply, to the power supply line, the power supply voltage at a first level in case where the piezoelectric element is to be resonated at the first frequency, and configured to apply, to the power supply line, the power supply voltage at a second level that is different from the first level in case where the piezoelectric element is to be resonated at the second frequency.

5. The oscillation device according to any one of claims 1 to 4, comprising
a resistor configured to detect a current of the transistor.

6. The oscillation device according to claim 5, comprising
a detection circuit configured to detect an amplitude of an oscillation voltage of the piezoelectric element.

7. The oscillation device according to claim 6, comprising
a control circuit configured to determine, based on the current of the transistor and the amplitude, whether or not the piezoelectric element is in an abnormal state.

8. The oscillation device according to claim 3, comprising a control circuit configured to switch the first switch and the second switch based on the first instruction and the second instruction.

9. A living body stimulation device configured to transmit vibration to a living body, the living body stimulation device comprising:
a piezoelectric element capable of resonating at a first frequency and a second frequency higher than the first frequency;
a transistor including a control electrode connected to the piezoelectric element, a power supply-side electrode, and a ground-side electrode;
a first coil connected to the ground-side electrode of the transistor;
a first capacitor connected in parallel to the first coil; and
a second capacitor connected between the first capacitor and the control electrode of the transistor, wherein
a resonant frequency of a resonant circuit constituted by the first coil and the first capacitor is higher than the first frequency and lower than the second frequency.
